# EUROPEAN PATENT APPLICATION

(11) **EP 2 546 866 A1**
(43) Date of publication of application: **16.01.2013**
(21) Application number: 12176113.4
(22) Date of filing: 12.07.2012
(51) Int. Cl.: H01L 21/20, H01L 21/02, C30B 29/40, C30B 25/14

(54) **Method of growing semiconductor epitaxial thin film and method of fabricating semiconductor light emitting device using the same**

(30) Priority: 12.07.2011 KR 20110068801
(71) Applicant: Samsung Electronics Co., Ltd., Suwon-si, Gyeonggi-do, 443-742 (KR)
(72) Inventor: Kim, Bum Joon, Seoul 138-190 (KR); Kim, Ki Sung, Gyeonggi-do 443-795 (KR); Maeng, Jong Sun, Gwangju 503-234 (KR); Ryu, Hyun Seok, Gyeonggi-do 443-756 (KR); Lee, Jung Hyun, Gyeonggi-do 425-130 (KR)
(74) Representative: Kuhnen & Wacker

(57) **Abstract**

A method of growing a semiconductor epitaxial thin film and a method of fabricating a semiconductor light emitting device using the same are provided. The method of growing a semiconductor epitaxial thin film, includes: disposing a plurality of wafers loaded in a wafer holder in a reaction chamber; and jetting a reactive gas including a chlorine organic metal compound to the wafers through a gas supply unit provided to extend in a direction in which the wafers are loaded, to grow a semiconductor epitaxial thin film on a surface of each of the wafers.

## Description

### CROSS-REFERENCE TO RELATED APPLICATIONS

This application claims the priority of Korean Patent Application No. 10-2011-0068801 filed on July 12, 2011, in the Korean Intellectual Property Office, the disclosure of which is incorporated herein by reference.

### BACKGROUND OF THE INVENTION

### Field of the Invention

The present invention relates to a method of growing a semiconductor epitaxial thin film and a method of fabricating a semiconductor light emitting device using the same.

### Description of the Related Art

Demand for nitride-based light emitting devices for use in mobile phone keypads, LED windows, backlight units (BLUs) for TVs and general illumination devices is growing rapidly. In order to meet this demand, the introduction of a sapphire wafer having a large diameter has been studied in connection with the replacement of a 4-inch sapphire wafer with a 6-inch sapphire wafer used to grow a nitride or oxide semiconductor (e.g., GaN, ZnO, etc.), applicable to a light emitting device, as an epitaxial thin film.

A current chemical vapor deposition process allows for manufacturing on a level of growing about 10 sheets of 4-inch sapphire wafers at a time. Also, a wafer having a large diameter may have problems associated therewith, such as a wafer bowing phenomenon, cracks generated due to high thermal stress resulting from a significant difference between a thermal expansion coefficient of a nitride semiconductor and that of a sapphire substrate used as a growth substrate and intrinsic stress resulting from a difference in lattice constants generated in growing a thin film, and a limitation due to a degradation of performance. In order to solve these problems, a batch-type chemical vapor apparatus is employed; however, this apparatus has characteristics in which a source gas is decomposed (or degraded) at a low temperature, thereby having difficulties in high temperature deposition.

### SUMMARY OF THE INVENTION

An aspect of the present invention provides a method of growing a semiconductor epitaxial thin film and a method of fabricating a semiconductor light emitting device capable of enhancing process efficiency.

Another aspect of the present invention provides a method of growing a semiconductor epitaxial thin film capable of reducing a phenomenon in which a nozzle for supplying a reactive gas is clogged.

Another aspect of the present invention provides a method of growing a semiconductor epitaxial thin film capable of enhancing productivity and preventing deformation of a wafer.

According to an aspect of the present invention, there is provided a method of growing a semiconductor epitaxial thin film, including: disposing a plurality of wafers loaded in a wafer holder in a reaction chamber; and jetting a reactive gas including a chlorine organic metal compound to the wafers through a gas supply unit provided to extend in a direction in which the wafers are loaded, to grow a semiconductor epitaxial thin film on a surface of each of the wafers.

The chlorine organic metal compound may be at least one of dimethyl gallium chloride (DMGaCl) and diethyl gallium chloride (DEGaCl).

The semiconductor epitaxial thin film may be a GaN thin film.

The reactive gas may be jetted together with a carrier gas including a hydrogen gas.

The method may further include adjusting a temperature within the reaction chamber with a heating unit disposed to surround an outer side of the reaction chamber.

The method may further include changing a growth temperature of the semiconductor epitaxial thin film while the semiconductor epitaxial thin film is being grown.

The reactive gas jetted from the gas supply unit may be jetted such that it flows to upper and lower surfaces of each of the wafers to grow an epitaxial thin film from both surfaces of each of the wafers.

The reactive gas may be jetted through the gas supply unit positioned between an internal tube of the reaction chamber, which is comprised of the internal tube having an internal space and an external tube covering the internal tube to maintain air-tightness, and the wafer holder.

The reactive gas may be jetted through a plurality of injection nozzles of the gas supply unit including at least one gas line supplying the reactive gas to the reaction chamber and the plurality of injection nozzles extending from the at least one gas line.

The plurality of injection nozzles may be arranged to face respective lateral sides of the loaded wafers or correspond to spaces between the loaded wafers so as to come between the loaded wafers to jet the reactive gas onto the respective wafers.

The method may further include cooling the reactive gas with a refrigerant flowing within a cooling line provided along the circumference of the gas line.

The method may further include supplying the same reactive gas through one or more gas supply units or discriminately supplying different reactive gases.

According to another aspect of the present invention, there is provided a method of fabricating a semiconductor light emitting device, including: disposing a plurality of wafers loaded in a wafer holder in a reaction chamber; and forming a light emitting structure including a first conductivity-type semiconductor layer, an active layer, and a second conductivity-type semiconductor layer on the wafer, wherein at least a portion of the light emitting structure includes a semiconductor layer grown by jetting a reactive gas including a chlorine organic metal compound to the wafer through a gas supply unit provided to extend in a direction in which the wafers are loaded.

The chlorine organic metal compound may be at least one of dimethyl gallium chloride (DMGaCl) and diethyl gallium chloride (DEGaCl).

The method may further include forming a buffer layer between the wafer and the light emitting structure.

At least a portion of the light emitting structure may be formed at a temperature higher than a temperature at which the buffer layer is formed.

A reactive gas of the buffer layer may include at least one of trimethyl gallium (TMGa), triethyl gallium (TEGa), trimethyl aluminum (TMA1), and trimethyl indium (TMIn).

A reactive gas of the light emitting structure may include at least one of DMGaCl (dimethyl gallium chloride) and DEGaCl (diethyl gallium chloride).

The semiconductor light emitting device may be a nitride gallium-based semiconductor light emitting device.

The reactive gas may be jetted together with a carrier gas including a hydrogen gas.

### BRIEF DESCRIPTION OF THE DRAWINGS

The above and other aspects, features and other advantages of the present invention will be more clearly understood from the following detailed description taken in conjunction with the accompanying drawings, in which:
FIG. 1 is a cross-sectional view schematically showing a chemical vapor deposition apparatus applicable to an embodiment of the present invention;
FIG. 2 is a plan view schematically showing the chemical vapor deposition apparatus of FIG. 1;
FIG. 3 is a view schematically showing a gas supply unit of the chemical vapor deposition apparatus applicable to an epitaxial thin film growing method according to an embodiment of the present invention;
FIGS. 4A and 4B are cross-sectional views showing positions in which injection nozzles are disposed in the chemical vapor deposition apparatus applicable to the epitaxial thin film growing method according to an embodiment of the present invention;
FIGS. 5A, 5B and 6 are views schematically showing another example of a gas supply unit of the chemical vapor deposition apparatus applicable to the epitaxial thin film growing method according to an embodiment of the present invention; and
FIG. 7 is a view schematically showing a structure of a light emitting structure fabricated according to a method of fabricating a semiconductor light emitting device according to an embodiment of the present invention.

### DETAILED DESCRIPTION OF THE PREFERRED EMBODIMENT

Embodiments of the present invention will now be described in detail with reference to the accompanying drawings.

The invention may, however, be embodied in many different forms and should not be construed as being limited to the embodiments set forth herein. Rather, these embodiments are provided so that this disclosure will be thorough and complete, and will fully convey the scope of the invention to those skilled in the art. In the drawings, the shapes and dimensions of elements may be exaggerated for clarity, and the same reference numerals will be used throughout to designate the same or like components.

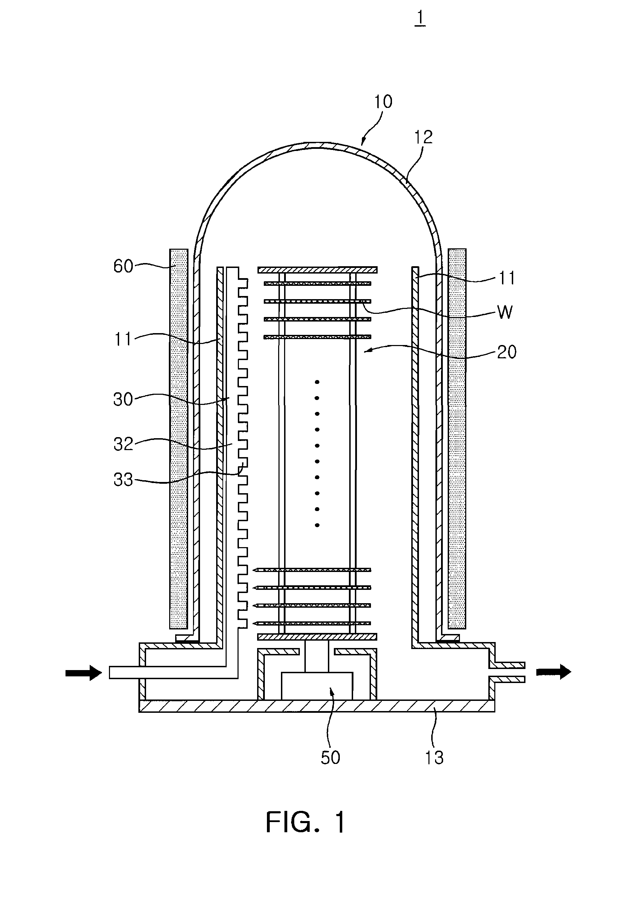

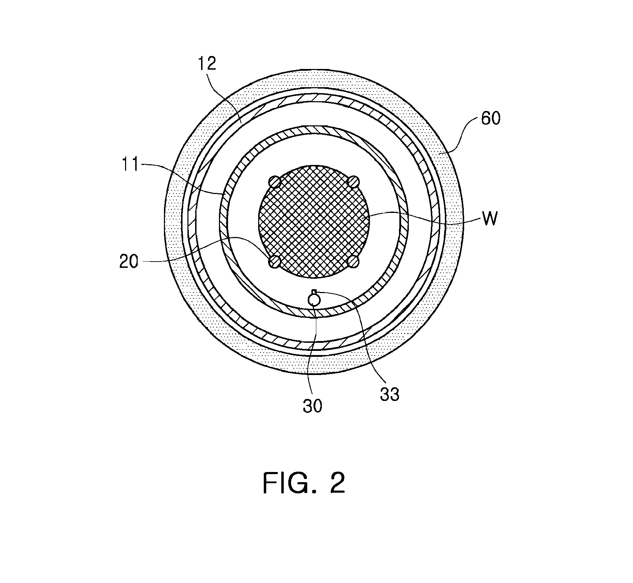

FIG. 1 is a cross-sectional view schematically showing a chemical vapor deposition apparatus applicable to an embodiment of the present invention, and FIG. 2 is a plan view schematically showing the chemical vapor deposition apparatus of FIG. 1. A method of growing a semiconductor epitaxial thin film according to an embodiment of the present invention may include an operation of disposing a plurality of wafers (W) loaded in a wafer holder 20, in a reaction chamber 10; and an operation of jetting a reactive gas including a chlorine organic metal compound to the wafers (W) through a gas supply unit 30 disposed to extend in a direction in which the wafers (W) are loaded, to grow a semiconductor epitaxial thin film on a surface of each of the wafers (W).

A chemical vapor deposition apparatus 1 applicable to an embodiment of the present invention is a so-called a vertical or a furnace-type chemical vapor deposition apparatus in which a plurality of wafers (W) are loaded at certain intervals in a vertical direction in the wafer holder 20, rather than being disposed on a susceptor, such that a reactive gas jetted through the injection nozzle to flow between the wafers (W).

In detail, with reference to FIGS. 1 and 2, the reaction chamber 10 of the chemical vapor deposition apparatus 1 may include an internal tube 11 having an internal space and an external tube 12 covering the internal tube 11 to maintain air-tightness, and a plurality of wafers (W) may be disposed at certain intervals in the wafer holder 20 disposed within the internal tube 11. Also, the gas supply unit 30, jetting a reactive gas to the wafers (W), is disposed between the internal tube 11 and the wafer holder 20 and extends vertically in the direction in which the wafers (W) are loaded. In detail, the reaction chamber 10 may be configured to have a dual-structure including the internal tube 11 having a cylindrical structure and the external tube 12 having an open lower portion and covering the internal tube 11 to maintain air-tightness. A base plate 13 may be provided at a lower portion of the internal tube 11 such that it may be opened and closed. The internal tube 11, the external tube 12, and the base plate 13 may be made of heat-resistant quartz or silicon carbide (SiC).

The plurality of wafers (W) for thin film growth are loaded in the wafer holder 20 at certain intervals, and the wafer holder 20 may be disposed within or discharged from the internal tube 11 by opening and closing the base plate 13. The wafer holder 20 may be made of a material such as quartz, or the like, so as not to be thermally deformed within the reaction chamber 10 under a high temperature and high pressure atmosphere, but the present invention is not limited thereto. According to the method of growing a semiconductor epitaxial thin film using the vertical chemical vapor deposition apparatus, hundreds sheets of wafers (W) may be loaded in the wafer holder 20 with a certain interval therebetween, thus allowing for a mass-production, in comparison to the related art in which only several sheets of wafers are mounted on a susceptor to grow a semiconductor epitaxial thin film.

Meanwhile, as shown in FIG. 1, the chemical vapor deposition apparatus 1 may further include a rotation driving unit 50 connected to the wafer holder 20 to rotate the wafer holder 20. The wafer holder 20 may be connected to the rotation driving unit 50 protected by an insulation board and rotated within the internal tube 11 by rotary force applied from the rotation driving unit 50. Since the wafer holder 20 is rotated by the rotation driving unit 50, the epitaxial thin film grown on the wafer (W) can be uniformly formed over the entire surface of the wafer.

Also, since a heating unit 60 is provided along the circumference of the reaction chamber 10, the interior of the reaction chamber 10 can be heated and maintained at a high temperature. As shown in FIGS. 1 and 2, the heating unit 60 may be disposed to surround an outer side of the reaction chamber 10, and increase an internal temperature of the reaction chamber 10 and uniformly maintain it by using a heating line (a heat wire or a hot wire) made of a material such as nichrome. Also, while the semiconductor epitaxial thin films are being grown, the internal temperature of the reaction chamber 10 may be changed by using the heating unit 60 such that the epitaxial thin films may be grown at different temperatures according to source materials (i.e., raw materials or base materials) or thin film characteristics.

The gas supply unit 30 may include at least one gas line 31 supplying a reactive gas from the outside to the interior of the reaction chamber 10 and a plurality of nozzles 33 communicating with the gas line 31 to jet the reactive gas to the wafers (W) to grow the semiconductor epitaxial thin films on the surfaces of the wafers (W).

In the method of growing a semiconductor epitaxial thin film according to the present embodiment, a plurality of wafers (W) are loaded with a certain interval therebetween in the wafer holder 20 disposed within the internal tube 11 of the reaction chamber 10 having the internal tube 11 having an internal space and the external tube 12 covering the internal tube 11 to maintain air-tightness, and a reactive gas including an organic metal compound including chlorine is jetted to the wafers (W) through the gas supply unit 30 provided to extend vertically in the direction in which the wafers (W) are loaded between the internal tube 11 and the wafer holder 20, thereby growing semiconductor epitaxial thin films on the surfaces of the plurality of wafers (W).

In the case of the vertical chemical vapor deposition apparatus, the gas supply unit 30 having a plurality of injection nozzles 33 for jetting a reactive gas to the respective wafers (W) is positioned within the reaction chamber 10 and the heating unit 60 is disposed on an outer side of the reaction chamber 10, so the reactive gas is exposed to a high temperature while moving within the gas supply unit 30 provided to extend vertically in the direction in which the plurality of wafers (W) are loaded. However, a reactive gas such as TMGa, TeGa, or the like, generally applied to fabricate a GaN-based semiconductor epitaxial thin film is decomposed (or degraded) at a relatively low temperature ranging from 300°C to 500°C, so it is decomposed within the nozzle before being jetted to the outside of the gas supply unit 30 of the reaction chamber 10 maintained at a high temperature of 1000°C or higher, causing problems in which process efficiency is degraded and the decomposed source material clogs the nozzle of the gas supply unit 30.

However, in the present embodiment, since an organic metal compound including chlorine is applied as a reactive gas for growing the semiconductor epitaxial thin film, the proportion of a decomposed reactive gas in the nozzle is reduced and the nozzle clogging phenomenon can be alleviated. For example, dimethyl gallium chloride ((CH₄)₂GaCl) or diethyl gallium chloride ((C₂H₅)₂GaCl) may be applied as a Ga source gas for growing a GaN thin film, and such a material is only rarely decomposed, even at a high temperature (it is decomposed at a temperature of 700°C to 800°C or higher). Thus, the proportion of the decomposed reactive gas within the gas supply unit 30 is reduced and the proportion of reactive gas decomposed on the surface of the wafer (W), namely, in the internal space of the internal tube 11, after being jetted from the gas supply unit 30, is increased, enhancing process efficiency. Also, since the reactive gas includes chlorine, a hydrogen chloride (HCl) gas, a compound of chlorine (Cl₂) and hydrogen (H₂), is generated, a remnant material within the gas supply unit 30 may be etched to reduce a nozzle clogging phenomenon.

In detail, decomposition reaction formulas of dimethyl gallium chloride or diethyl gallium chloride mentioned above as examples are as follows:

DEGaCl (diethyl gallium chloride): (C₂H₅)2GaCl → GaCl(g) + 2C₂H₄(g) + H₂(g); and

DMGaCl (dimethyl gallium chloride): (CH₄)₂GaCl → GaCl(g) + 2C₂H₃(g) + H₂(g).

Namely, Cl of GaCl generated when diethyl gallium chloride or dimethyl gallium chloride is degraded reacts to H₂ as a degradation product or a hydrogen gas (H₂) applied as a carrier gas for carrying the reactive gas, to generate a hydrogen chloride (HCl) gas as an etching gas. A thusly generated hydrogen chloride (HCl) gas acts as an etching gas within the gas line 31 or the injection nozzle 33 of the gas supply unit 30 to remove some remnant materials degraded in the gas supply unit 30.

Meanwhile, the reactive gas jetted from the gas supply unit 30 flows along the surfaces of the respective wafers (W) to form a GaN epitaxial thin film on the surfaces of the plurality of respective wafers (W) through the following reaction formula shown below:

GaCl(g) + NH3(g) → GaN(s) + HCl(g) + H₂(g).

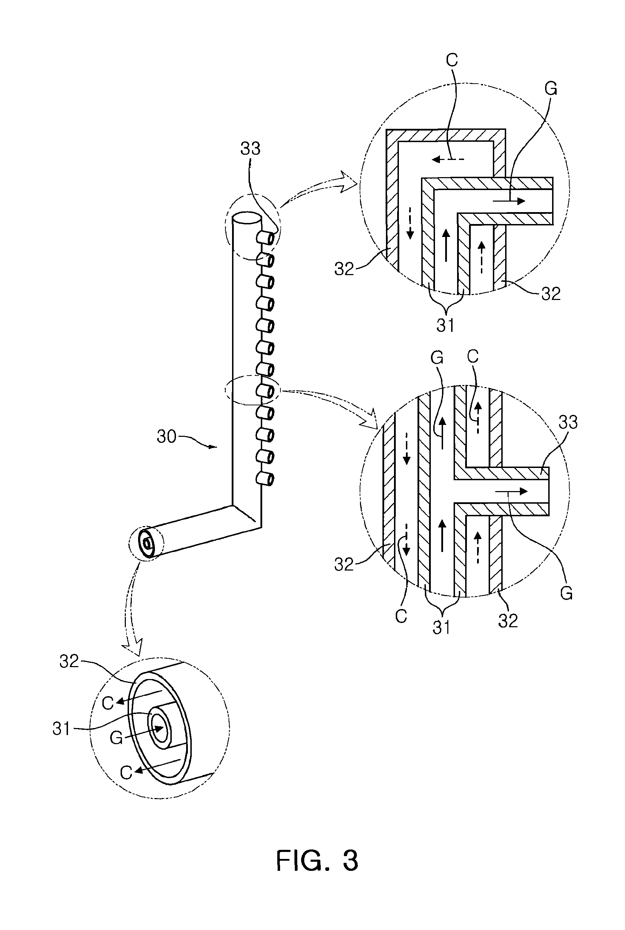

FIG. 3 is a view schematically showing a gas supply unit of the chemical vapor deposition apparatus applicable to the method of growing an epitaxial thin film according to an embodiment of the present invention. With reference to FIG. 3, the gas supply unit 30 includes at least one gas line 31 supplying a reactive gas (G) from the outside to the interior of the reaction chamber 10 and a plurality of injection nozzles 33 jetting the reactive gas (G) to the wafers (W) to grow semiconductor epitaxial thin films on the surfaces of the wafers (W). Also, the gas supply unit 30 may further include a cooling line 32 provided along the circumference of the gas line 31 to cool the reactive gas (G).

In detail, the gas supply unit 30 including the gas line 31 and the cooling line 32 may be provided to extend vertically in the direction in which the wafers (W) are loaded between the internal tube 11 and the wafer holder 20, and may have a dual-structure in which the gas line 31 is disposed within the cooling line 32. Namely, the gas line 31 in which the reactive gas flows is surrounded by the cooling line 32 in which a refrigerant (C) flows, to cool the reactive gas (G), whereby the reactive gas (G) is prevented from reacting while being supplied to the interior of the reaction chamber 10 along the gas line 31 otherwise under a high temperature atmosphere so as to be deposited within the gas line 31. A plurality of injection nozzles 33 may be protruded from the gas supply unit 30, specifically, on the surface of the cooling line 32 in a length direction of the cooling line 32 and provided at positions corresponding to the positions of the respective wafers (W). The plurality of injection nozzles may communicate with the gas line 31. This, however, is an example of the chemical vapor deposition device applicable to the method of growing an epitaxial thin film according to an embodiment of the present invention and the operation of cooling the reactive gas through a refrigerant flowing in the cooling line 32 may be omitted as necessary.

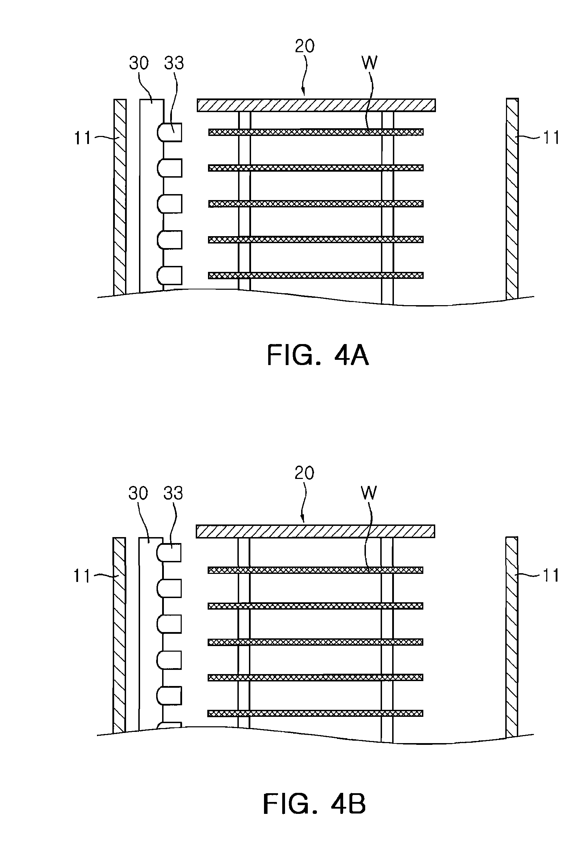

FIGS. 4A and 4B are cross-sectional views showing positions in which injection nozzles are disposed in the chemical vapor deposition apparatus applicable to the epitaxial thin film growing method according to an embodiment of the present invention. First, with reference to FIG. 4A, the plurality of injection nozzles 33 are arranged to correspond to intervals at which the wafers (W) are loaded such that the nozzles 33 face the lateral sides of the respective loaded wafers (W). Also, as shown in FIG. 4B, the plurality of injection nozzles 33 may be arranged to come between the loaded wafers (W), and in this case, the injection nozzles 33 may jet the reactive gas (G) to the surfaces of the plurality of wafers (W) to form an epitaxial thin film on each of the respective wafers (W).

In detail, the injection nozzle 33 may jet the reactive gas (G) to one surface, i.e., an upper surface, of each wafer (W) to form an epitaxial thin film 80 on only the upper surface of each wafer (W), or may jet the reactive gas (G) to upper and lower surfaces of each wafer (W) to simultaneously form the epitaxial thin film on the upper and lower surfaces of each wafer (W). Namely, each of the plurality of injection nozzles 33 may be disposed to correspond to each of the loaded wafers (W) and jet the reactive gas (G) such that the reactive gas (G) flows on the upper and lower surfaces of each wafer (W), thus growing the epitaxial thin film 80 from both surfaces of the upper and lower surfaces of each wafer (W). When the epitaxial thin film 80 is formed on both surfaces of each wafer (W), a light emitting structure 80' including two epitaxial thin films can be obtained on the single wafer (W), enhancing productivity.

Also, the growth of the epitaxial thin film 80 from both surfaces of the wafer (W) can prevent the wafer (W) from being deformed due to stress. Namely, when the epitaxial thin film 80 is only grown on one surface of the wafer (W) as in the related art chemical vapor deposition device, a large amount of stress acts on the epitaxial thin film 80 to cause a bowing phenomenon, making the epitaxial thin film 80 have a curved shape, and this phenomenon may be aggravated as the diameter of the wafer is increased to potentially damage the wafer or degrade performance. However, in the present embodiment, since the epitaxial thin film 80 is grown on both surfaces of the wafer (W), the stress generated on upper and lower surfaces of the wafer (W) is alleviated to solve the problems of the related art.

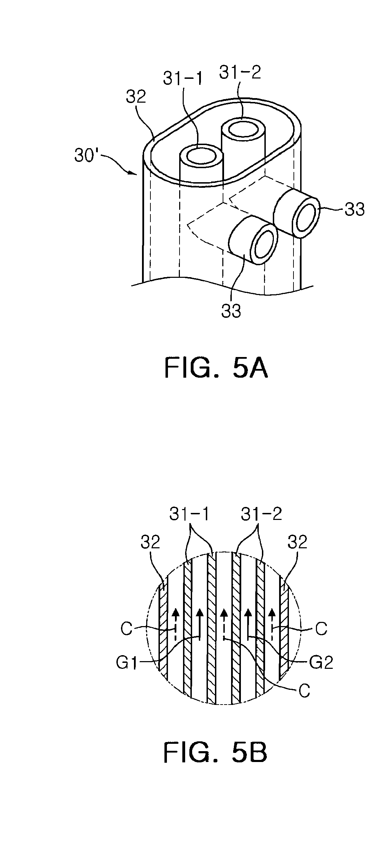

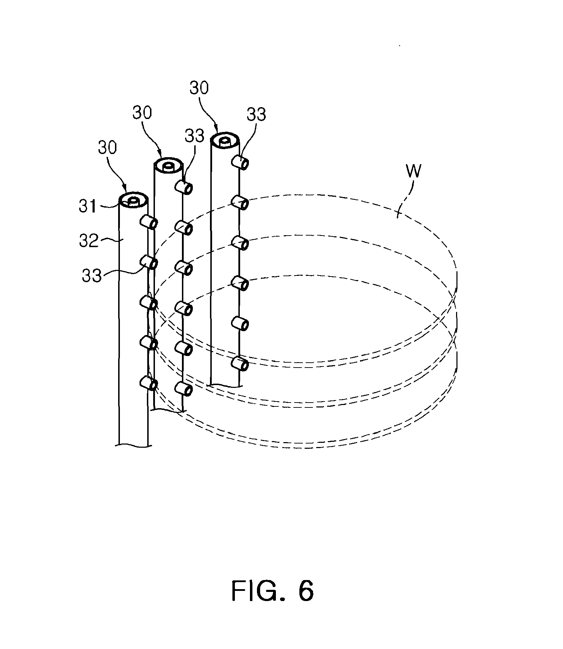

FIGS. 5A, 5B and 6 are views schematically showing another example of a gas supply unit of the chemical vapor deposition apparatus applicable to the epitaxial thin film growing method according to an embodiment of the present invention. First, with reference to FIGS. 5A and 5B, a gas supply unit 30' may include a first gas line 31-1 supplying a first reactive gas G1 and a second gas line 31-2 supplying a second reactive gas G2. The first and second gas lines 31-1 and 31-2 may be disposed within the cooling line 32. Namely, unlike the embodiment illustrated in FIG. 3, two or more gas lines 31-1 and 31-2 are provided within the cooling line 32 to discriminately supply the first reactive gas G1 and the second reactive gas G2, and when different source gases are applied to some of the light emitting structure as described above, the different source gases may be separately supplied through the first and second gas lines 31-1 and 31-2 of the gas supply unit 30'.

Also, as shown in FIG. 6, two or more gas supply units 30 may extend vertically in the direction in which the wafers (W) are loaded between the internal tube 11 and the wafer holder 20. Here, the respective gas supply units 30 may discriminately supply different reactive gases, and may include a single or a plurality of gas lines. However, this configuration is merely an example of the chemical vapor deposition device applicable to the method of growing a semiconductor epitaxial thin film according to an embodiment of the present invention and a specific configuration of the chemical vapor deposition device may be variably modified.

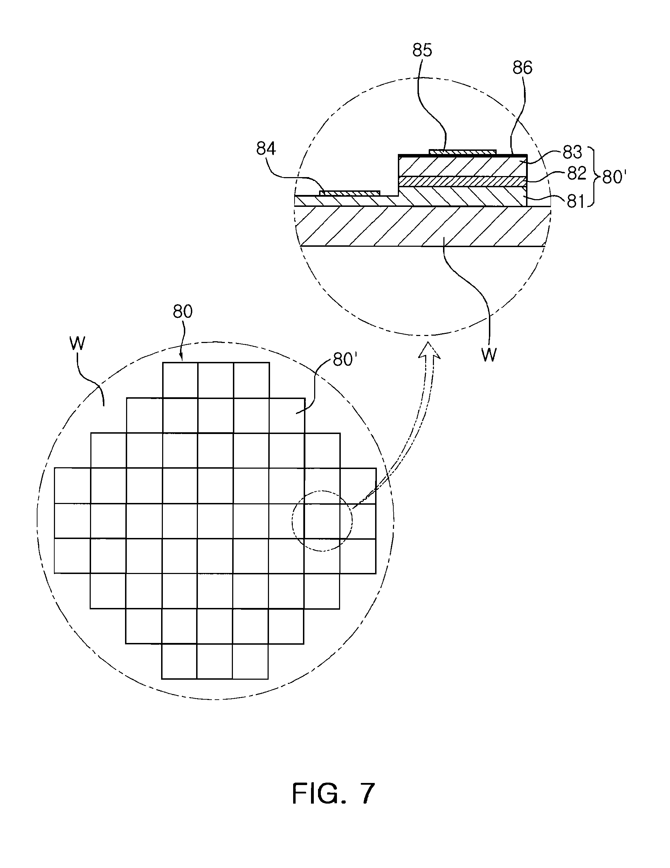

FIG. 7 is a view schematically showing a structure of a light emitting structure fabricated according to a method of fabricating a semiconductor light emitting device according to an embodiment of the present invention. The method of fabricating a semiconductor light emitting device according to the present embodiment includes disposing a plurality of wafers (W) loaded in a wafer holder in the reaction chamber 10 and forming the light emitting structure 80' including a first conductivity-type semiconductor layer 81, an active layer 82, and a second conductivity-type semiconductor layer 82, wherein at least a portion of the light emitting structure 80' may include a semiconductor layer grown by jetting a reactive gas including a chlorine organic metal compound through the gas supply unit 30 disposed to extend in the direction in which the wafers (W) are loaded.

With reference to FIG. 7, the first conductivity-type semiconductor layer 81, the active layer 82, and the second conductivity-type semiconductor layer 83 are sequentially grown on the surface of the wafer (W) to form the light emitting structure 80', and the first and second conductivity-type semiconductor layers 81 and 83 forming the light emitting structure 80' may be n-type and p-type semiconductor layers, respectively, and may be made of a nitride semiconductor. Thus, in the present embodiment, the first and second conductivity-types may be understood to mean n-type and p-type conductivities, respectively, but the present invention is not limited thereto.

The first and second conductivity-type semiconductor layers 81 and 83 may have an empirical formula AlₓIn_{y}Ga_{(1-x-y)}N (here, 0≤x≤1, 0≤y≤1, 0≤x+y≤1), and such a material may include GaN, AlGaN, InGaN, and the like. The active layer 82 disposed between the first and second conductivity-type semiconductor layers 81 and 83 emits light having a certain level of energy according to electron and hole recombination, and may have a multi-quantum well (MQW) structure in which quantum well layers and quantum barrier layers are alternately stacked. Here, the MQW structure may be, for example, an InGaN/GaN structure. Meanwhile, the first conductivity-type semiconductor layer 81 may be doped with impurities such as Si, Ge, Se, Te, C, or the like, and the second conductivity-type semiconductor layer 83 may be doped with impurities such as Mg, Zn, Be, or the like.

First and second conductivity-type electrodes 84 and 85 may be formed on the first and second conductivity-type semiconductor layers 81 and 83 and electrically connected to the first and second conductivity-type semiconductor layers 81 and 83, respectively. As shown in FIG. 7, the first conductivity-type electrode 84 may be formed on the first conductivity-type semiconductor layer 81 exposed as portions of the second conductivity-type semiconductor layer 83, the active layer 82, and the first conductivity-type semiconductor layer 81 are etched, and the second conductivity-type electrode 85 may be formed on the second conductivity-type semiconductor layer 83. In this case, in order to enhance an ohmic-contact function between the second conductivity-type semiconductor layer 83 and the second conductivity-type electrode 85, a transparent electrode 86 made of ITO, ZnO, or the like, may be further provided therebetween.

Here, as for the reactive gas, trimethyl gallium (TMGa), triethyl gallium (TEGa), trimethyl indium (TMIn), triethyl indium (TEIn), trimethyl aluminum (TMAl), triethyl aluminum (TEAl), or the like, may be applied as a source gas of a gallium nitride-based compound semiconductor (Ga (Al, In)N), mono silane (SiH₄) or disilane (Si₂H₈) may be applied a Si doping source material of the n-type semiconductor layer, and an organic germanium compound such as germane gas (GeH₄), tetramethyl germanium ((CH₃)₄Ge), tetraethyl germanium ((C₂H₅)₄Ge), or the like, may be applied as a Ge doping source material. Also, biscyclopentadienyl magnesium (Cp₂Mg), bisethylcyclopentadienyl magnesium (EtCp₂Mg), or the like, may be applied as an Mg doping source material of the p-type semiconductor layer. Meanwhile, in the present embodiment, in the process of growing the light emitting structure, an organic metal compound including chloride, e.g., dimethyl gallium chloride or diethyl gallium chloride may be used, as a reactive gas of Ga.

The nitride gallium-based compound semiconductor grown by the reactive gas including such source materials may contain a different Group III element in addition to Al, Ga, and In, or may contain a dopant element such as Ge, Si, Mg, Ca, Zn, Be, or the like, as necessary. Also, without being limited to the intentionally added elements, the nitride gallium-based compound semiconductor may include the impurities inevitably included according to film formation conditions, or the like, a small amount of impurities included in source materials and a reaction tube material.

In the present embodiment, it is described that the entirety of the light emitting structure 80' is formed by the reactive gas including the organic metal compound including chlorine, but, alternatively, a portion of the light emitting structure 80', e.g., at least one of a substrate, a buffer layer, the n-type semiconductor layer, the active layer, the p-type semiconductor layer may be formed. Specifically, a buffer layer (not shown) made of a nitride, or the like, may be grown between the wafer (W) and the light emitting structure 80, and after the buffer layer is grown by using TMGa, TEGa, or the like, as a source gas at a low temperature (500°C), the temperature of the reaction chamber 10 may be increased through the heating unit 60 to grow an n-type or p-type semiconductor layer by using dimethyl gallium chloride (DMGaCl) or diethyl gallium chloride (DEGaCl) having a fast growth speed at a high temperature, as a source gas. Here, however, the reactive gas including the chlorine organic metal compound is not necessarily applied to grow only a portion of the light emitting structure 80. For example, contrary to the foregoing example, the reactive gas including the chlorine organic metal compound may be applied in various manners or orders, such that it is applied only to the formation of a buffer layer or only to the formation of a GaN substrate.

In addition, although not shown, a nitride-based field effect transistor (FET) or a portion thereof, as well as the light emitting structure, may be fabricated by forming a buffer layer, a GaN thin film, a source, a gate, and a drain on an upper surface of the substrate (wafer) by using the method of growing an epitaxial thin film according to an embodiment of the present invention.

As set forth above, according to embodiments of the invention, the semiconductor epitaxial thin film growing method having process efficiency enhanced by reducing the proportion of the decomposed (or degraded) reactive gas in the gas supply unit can be provided.

In addition, the semiconductor epitaxial thin film growing method having a nozzle clogging phenomenon alleviated by etching a material remaining in the gas supply unit can be provided, and also, the semiconductor epitaxial thin film growing method capable of preventing a wafer from being deformed by stress can be provided.

While the present invention has been shown and described in connection with the embodiments, it will be apparent to those skilled in the art that modifications and variations can be made without departing from the spirit and scope of the invention as defined by the appended claims.

## Claims

1. A method of growing a semiconductor epitaxial thin film, the method comprising:
disposing a plurality of wafers loaded in a wafer holder in a reaction chamber; and
jetting a reactive gas including a chlorine organic metal compound to the wafers through a gas supply unit provided to extend in a direction in which the wafers are loaded, to grow a semiconductor epitaxial thin film on a surface of each of the wafers.

2. The method of claim 1, wherein the chlorine organic metal compound is at least one of dimethyl gallium chloride (DMGaCl) and diethyl gallium chloride (DEGaCl).

3. The method of claim 1 or 2, wherein the semiconductor epitaxial thin film is a GaN thin film.

4. The method of any one of claims 1 to 3, wherein the reactive gas is jetted together with a carrier gas including a hydrogen gas.

5. The method of any one of claims 1 to 4, further comprising adjusting a temperature within the reaction chamber with a heating unit disposed to surround an outer side of the reaction chamber.

6. The method of any one of claims 1 to 5, further comprising changing a growth temperature of the semiconductor epitaxial thin film while the semiconductor epitaxial thin film is being grown.

7. The method of any one of claims 1 to 6, wherein the reactive gas jetted from the gas supply unit is jetted such that it flows to upper and lower surfaces of each of the wafers to grow an epitaxial thin film from both surfaces of each of the wafers.

8. The method of any one of claims 1 to 7, wherein the reactive gas is jetted through the gas supply unit positioned between an internal tube of the reaction chamber, which is comprised of the internal tube having an internal space and an external tube covering the internal tube to maintain air-tightness, and the wafer holder.

9. A method of fabricating a semiconductor light emitting device, the method comprising:
disposing a plurality of wafers loaded in a wafer holder in a reaction chamber; and
forming a light emitting structure including a first conductivity-type semiconductor layer, an active layer, and a second conductivity-type semiconductor layer on the wafer,
wherein at least a portion of the light emitting structure includes a semiconductor layer grown by the method of any one of claims 1 to 8.

10. The method of claim 9, further comprising forming a buffer layer between the wafer and the light emitting structure,
wherein at least a portion of the light emitting structure is formed at a temperature higher than a temperature at which the buffer layer is formed.

11. The method of claim 10, wherein a reactive gas used as a source gas for the growth of the buffer layer includes at least one of trimethyl gallium (TMGa), triethyl gallium (TEGa), trimethyl aluminum (TMAl), and trimethyl indium (TMIn).

12. The method of any one of claims 9 to 11, wherein the semiconductor light emitting device is a nitride gallium-based semiconductor light emitting device.
